# EUROPÄISCHE PATENTANMELDUNG

(11) **EP 0 616 259 A1**
(43) Veröffentlichungstag der Anmeldung: **21.09.1994**
(21) Anmeldenummer: 94103022.3
(22) Anmeldetag: 01.03.1994
(51) Int. Cl.: G03F 9/00

(54) **Verfahren zum Herstellen eines Flexodruck-Klischees**

(30) Priorität: 16.03.1993 DE 4309258
(71) Anmelder: Hornschuh, Manfred, Dipl.-Des.-Ing., D-49174 Hilter (DE)
(72) Erfinder: Hornschuh, Manfred, Dipl.-Des.-Ing., D-49174 Hilter (DE)
(74) Vertreter: von Raffay, Vincenz, Dipl.-Ing.

(57) **Zusammenfassung**

Das Verfahren zum Herstellen eines Flexodruck-Klischees geht von einem Klischeerohling mit einer Base (Polyesterfolie) und einer auf dieser angeordneten weichen, mit Fotoinitiatoren angereicherten, Kautschukmasse (Polymer) aus. Der das zu druckende Motiv aufweisende Film wird auf der Oberfläche der Kautschukmasse paßgerecht befestigt. Um die Anordnung und Montage mit Hilfe von bekannten Montageschienen mit Paßstiften und entsprechenden Stanzlöchern zu ermöglichen, wie sie im Offset- oder Tiefdruckverfahren bekannt sind, arbeitet das erfindungsgemäße Verfahren wie folgt:
a) die Kautschukmasse (1) wird an den für die Befestigung vorgesehenen Rändern (3) von der Base (2) entfernt;
b) die Base wird im Bereich dieser freigelegten Ränder mit Paßlöchern (4) versehen, und mit diesen auf Paßstifte (5) einer Montageschiene (6) aufgesetzt;
c) auf die befreiten Ränder werden Distanzstücke (7) aufgelegt, deren Höhe der Höhe der entfernten Kautschukmasse entspricht;
d) der entsprechende Paßlöcher (9) aufweisende Film (8) wird auf die Paßstifte aufgelegt;
e) dann wird in üblicher Weise die Belichtung, das Auswaschen und die Montage in der Druckmaschine vorgenommen.

Hierdurch ist eine paßgenaue Herstellung des Klischees für ein Flexodruckverfahren möglich. Gleichzeitig ist eine exakte Montage in der Druckmaschine möglich. Diese Montage kann als sog. "Streßmontage" durchgeführt werden, d.h. die Montage kann unter Druck erfolgen, so daß Höhentoleranzen ausgeglichen werden können. Hierdurch wird die Druckgenauigkeit weiter erhöht.

## Beschreibung

Die Erfindung betrifft eine Verfahren nach dem Oberbegriff des Patentanspruches 1.

Derartige Verfahren sind zur Vorbereitung eines Flexodruckverfahrens, das ein Hochdruckverfahren ist, grundsätzlich bekannt. Bei diesen Verfahren wird Druckfarbe auf das Klischee aufgetragen. Unter Druckspannung überträgt das Klischee in der Druckmaschine die Farbe auf den Druckstoff.

Als Klischeematerial stehen vulkanisierte Gummiplatten, gelaserte Gummiplatten und gelaserte, gummibeschichtete Zylinder sowie fotopolymere Platten und fotopolymer-beschichtete Zylinder zur Verfügung.

Bei den fotopolymeren Druckplatten sind zwei Systeme am Markt bekannt, das Liquid- und das Solidsystem.

Im Qualitätsflexodruck werden überwiegend Solidplatten eingesetzt, deren Marktanteil - nach Herstellerangaben - Eine mit Fotoinitiatoren angereicherte, extrem weiche Kautschukmasse, wird auf eine Polyesterfolie - zwischen 0,127 bis 0,229 mm - in einer Stärke von 0,513 mm bis 6,223 mm extrudiert und über Kalander oberflächenhomogenisiert, mit Totaltoleranzen von +/- 10 µm.

Durch die Addition der Stärke der Base und der des Polymers entstehen Klischees in Gesamthöhen zwischen 0,640 mm und 6,350 mm.

Zur Herstellung der druckfertigen Klischees wird ein seitenrichtiges Mattnegativ benötigt, bei dem die später zu druckenden Teile lichtdurchlässig sind. Der Film und die fotopolymere Rohplatte werden unter Vakuum in einem UV-Belichter mit UV-Licht belichtet. Die im Film durchlässigen Partien härten durch das eindringende UV-Licht die Teile der Platte, die später die Farbe übertragen. In einem Wascher werden die nicht belichteten Teile ausgewaschen, so daß die später zu druckenden Partien seitenverkehrt erhaben auf der Platte stehen.

Die Flexodruckmaschinen haben in der Regel 6 bzw. 8 Druckwerke, so daß 6- bzw. 8-farbig in einem Arbeitsgang gedruckt werden kann. Alle Farben, die in einem Arbeitsgang gedruckt werden, müssen zueinanderpassen. Um das, relativ gesehen, zu ermöglichen, werden links und rechts neben dem Druckbild, mittig angeordnet, Paßkreuze abgebildet.

Dabei wird versucht, alle Paßkreuze aller 6- bzw. 8-farbigen Druckformen annähernd deckungsgleich anzuordnen. Über Spiegelsysteme oder über Videokameras wird das Paßkreuz der ersten Farbe positioniert und die Paßkreuze der nachfolgenden Platten danach ausgerichtet.

Verfahren, die Löcher in die fertige Druckplatte (durch gehärtetes Polymer und durch die Base) bohren oder stanzen, positionieren ebenfalls nach Paßkreuzen. Bedingt durch die hohe Kompressibilität - auch des bereits gehärteten Polymers - sind durch die Federung der Platte selbst exakte reproduzierbare Löcher nicht zu erreichen. Zwischen der Druckoberfläche und der Base bei den Plattenstärken von 0,64 und 0,76 mm liegt ein Relief von 0,513 mm bzw. 0,633 mm. Die Relieftiefen bei allen anderen Druckplatten zwischen der Druckoberfläche und dem polymeren Sockel liegen zwischen 0,8 und 1,5 mm. Der Wechsel zwischen druckenden Teilen und nichtdruckenden Teilen gestattet keine flächenparallele Auflage für den Bohr- bzw. Stanzvorgang.

Die Platte federt durch die unterschiedlichen Höhen. Darüberhinaus bleiben Polymerreste am Werkzeug haften und vegrößern dadurch das jeweilige Loch in der Base.

Die Passer der konventionellen Druckverfahren - Offset und Tiefdruck - liegen bei 0,050 bis 0,100 m. Beim derzeitigen Stand der Technik ist eine offsetgenaue Montage im Flexo nicht zu erreichen.

Bei der Filmherstellung der konventionellen Verfahren wird der reprotechnische Passer über Stanzungen erreicht. D.h., der unbelichtete Film wird unmittelbar nach der Entnahme aus dem Filmspender in einer Filmstanze gestanzt und in einer Montageschiene mit erhabenen Paßstiften eingelegt und ggf. mit einem bereits belichteten, ebenfalls gestanzten Film, in Kontakt gebracht und belichtet. Die Paßgenauigkeit wird nicht über montierte Paßkreuze, sondern über das beschriebene Stanz-Lochsystem mit Genauigkeiten von +/- 10 µm erreicht.

Die Offsetdruckplattenkopie arbeitet nach dem gleichen Prinzip der Loch/Stanzung zwischen Film und Platte und der Montage über Paßstifte.

Der Flexo arbeitet bei der Filmherstellung ebenfalls über die Filmstanzung. Aber schon der Endfilm ist nicht mehr gestanzt, weil bislang eine weitere Verwendung gestanzter Endfilme mit zu belichtenden, gestanzten Rohplatten nicht möglich war.

Die Plattenstärken, die im Flexo eingesetzt werden, variieren in der Höhe zwischen 0,644 und 6,35 mm.

Die Härtegrade zwischen den Rohplatten und zwischen den Fertigplatten variieren ebenfalls extrem. Bei den Rohplatten zwischen 8°Shore-A bis 19°Shore-A, die späteren Fertigplatten, nach Belichtung und Nachbehandlung, ca. zwischen 42 und 65°Shore-A.

Weder paßgenaues Stanzen noch paßgenaues Bohren ist durch die weiche Rohplatte möglich. Allein durch den Stanz- und Bohrvorgang würde bei der Auflage eines Werkstückes die extrem weiche Polymermasse auf der Base beschädigt und die Druckplatte würde dadurch unbrauchbar.

Sowohl bei einem evtl. Bohr- wie auch Stanzvorgang würde das weiche Polymer weder innerhalb einer Masse ein exaktes Bohrloch gestatten noch in der Base.
Polymeranteile lagerten sich während des Bohr- bzw. Stanzvorganges an der Außenseite des Werkzeuges ab und zögen einen Teil dieser Masse mit in die Bohrrichtung, bis durch die Base.

Das Material in der Bohrstelle "sackt" nach. Eine exakte Paßstiftführung ist dadurch weder in den "unrunden" Löchern der Base noch in den "unrunden" Löchern des Polymers möglich.

Der Erfindung liegt die Aufgabe zugrunde, ein Verfahren der eingangs genannten Art zu schaffen, durch das es möglich ist, die Anordnung des Films auf dem Klischee und die Montage des fertiggestellten Klischees in der Druckmaschine paßgenau mit den erforderlichen Toleranzen mit Hilfe von Montageschienen und Paßstiften durchzuführen.

Diese Aufgabe wird durch das Kennzeichen des Patentanspruches 1 gelöst.

Erfindungsgemäß wird erreicht, daß die Passer der konventionellen Druckverfahren, wie Offset- oder Tiefdruck, auch zur genauen Montage im Flexodruckverfahren eingesetzt werden können. Dieses geschieht durch die Merkmale des kennzeichnenden Teils des Patentanspruches 1.

Dadurch, daß erfindungsgemäß vorzugsweise mit Hilfe eines thermischen Messers in den zu stanzenden Randbereichen die Kautschukmasse entfernt wird, ist es möglich, die dünne und entsprechend harte Base exakt und paßgenau zu stanzen. Mit Hilfe der Distanzstücke ist dann die Anordnung des das Motiv aufweisenden Films möglich. Nach dem Belichten und Fertigstellen des Klischees kann dieses ebenfalls paßgenau in der Druckmaschine montiert werden.

Die Erfindung besteht also in einer Verfahrenstechnik, die es erstmals möglich macht, durch Stanzung der Rohplatte die Kautschukmasse paßgenau zu belichten und im Anschluß an den Fertigungsprozeß die ausgewaschene und nachbehandelte Platte unter Streß, d.h. unter Druck, zu montieren.

Neben der Fertigungsgenauigkeit wird dadurch die Plattenmontage zeitlich um ca. 75 % verkürzt. Die Paßgenauigkeit der montierten Zylinder, die bei dem heutigen Stand der Plattenmontage durchschnittlich zwischen 0,3 mm bis 0,8 mm liegt, würde durch diese neue Verfahrenstechnik auf Werte zwischen 0,05 bis 0,1 mm verringert.

In einer dafür konstruierten Maschine wird die später zu belichtende, rohe, fotopolymere Druckplatte unter Vakuum und gegen Anschlag fixiert. Die Höhe der polymeren Schicht auf der Base wird abgetastet, ebenso die Härte des Polymers.

Aus den Daten der gemessenen Polymermenge und denen der Härte ermittelt der Rechner die zu benötigende Energie für den Abtrennvorgang und für den Vorschub.

Der Schneidekopf in Form von flach gekanteten oder rotierenden Rundmassen ist vorzugsweise aber als thermisches Messer ausgelegt.

Die elektronisch gesteuerte, thermische Schneidvorrichtung hebt, ausgerichtet auf die Spezifikation des Polymers (Stärke/Härte) das Material von der Base ab.

Die Kühlung des Schneidemessers kann separat erfolgen, vorzugsweise aber durch das auszuhebende und stehenbleibende Material selbst. Die Energie für die thermische Schneidvorrichtung wird so berechnet, daß mit der Koppelung des Vorschubs nur in der unmittelbaren Berührungszone das Material angeschmolzen, gleichzeitig aber durchtrennt werden kann. Damit wird ein "Ankleben" bzw. "Anbrennen" des polymeren Rohmaterials verhindert. Der Vorschug kann manuell oder motorisch, sollte aber vorzugsweise pneumatisch erfolgen. Durch den pneumatischen Antrieb wird die Kraft so dosiert, daß der thermische Schneidkopf nur in der vorderen schneidenden Berührungszone soviel Energie freisetzt, daß das Material in dieser Zone angeschmolzen und gleichzeitig durchtrennt werden kann. Durch den pneumatischen Druck wird das Messer unmittelbar und permanent nach der Durchtrennung weitergeführt. Die Zone vor dem thermischen Messer ist noch kalt, die Zone unmittelbar hinter dem Messer ist bereits wieder so weit abgekühlt, daß das Material unterhalb des Anschmelzpunktes liegt.

Durch den Schmelzvorgang des thermischen Messers wird das stehenbleibende Material an der Schnittkante geglättet. Dadurch wird verhindert, daß Polymerreste frei werden und sich störend auf die Platte legen können.

Die so von der klebrigen weichen Polymermasse befreite Base kann in der gleichen handelsüblichen Filmstanze, mit der auch das Negativ gestanzt wurde, gestanzt werden.

Die Paßstifte der handelsüblichen Montageschiene müssen auf die Höhe der Polymerplatten (0,76 bis 6,35 mm) verlängert werden. In die so geänderte Montageschiene wird die später zu belichtende Platte paßgerecht eingebracht, ein Distanzstück in der Höhe des ausgehobenen Polymers schafft die Parallelität zwischen der zu belichtenden Rohplatte und der Stanzlochseite. Nach Aufnahme des gestanzten Negatives kann die Platte unter Vakuum exakt und paßgerecht belichtet werden.

Durch diese neue Verfahrenstechnik kann zum ersten Mal Film und Rohplatte paßgerecht belichtet werden und in der gleichen Technologie paßgerecht montiert werden.

In einem geeigneten Montagegerät wird in einer Nutlinie eine auf die Erfindung ausgerichtete, neu zu schaffende Matrize mit der gleichen Lochanordnung der Stanze eingebracht, positioniert und fixiert.

Die Löcher der polymerfreien Base der ausgewaschenen Platte nimmt eine Patrize, mit gleicher Stiftanordnung der Stanze, auf.

Die Patrize wird mit der eingehangenen Platte in die Matrize eingebracht. Damit ist die Druckplatte exakt positioniert und kann jetzt erstmals unter Streß, d.h. mit der gleichen Druckbeistellung, wie sie später in der Druckmaschine gefahren wird, montiert werden.

Durch die Erfindung ist erstmals eine Streßmontage und erstmals dadurch exakt gleiche Abwicklungen aller Platten einer 6- bzw. 8-farbigen Druckform möglich.

Im folgenden wird die Erfindung unter Hinweis auf die Zeichnung anhand eines Ausführungsbeispieles näher erläutert.

Es zeigt:
- Fig. 1: eine perspektivische Ansicht eines Flexodruck-Klischees vor der Belichtung und Bearbeitung;
- Fig. 2: eine der Fig. 1 entsprechende perspektivische Ansicht eines Klischees, jedoch nach dem Entfernen der Kautschukmasse an einem Randabschnitt;
- Fig. 3: eine den Fig. 1 und 2 entsprechende perspektivische Ansicht nach dem Stanzen der Paßlöcher in dem entsprechenden Randabschnitt;
- Fig. 4: eine perspektivische Ansicht eines Klischees aufgesetzt auf Paßstifte und mit einem das zu druckende Motiv aufweisenden Film;
- Fig. 5: eine Seitenansicht eines Klischees mit einem thermischen Messer während des Abtrennvorganges; und
- Fig. 6: eine Draufsicht auf die Darstellung der Fig. 5.

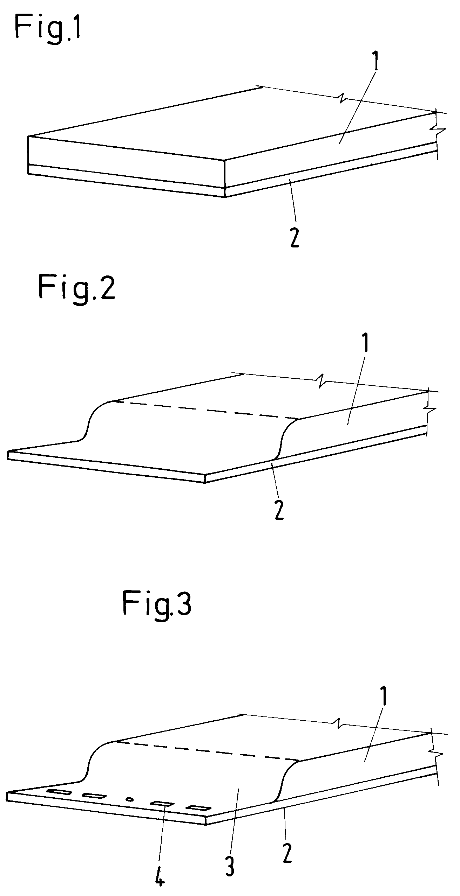

In den Fig. 1 bis 4 ist ein hohes Flexodruck-Klischee (Fig. 1) dargestellt, das aus einer Kautschukmasse 1 (Rohpolymer) und einer Base (2) (Polyesterfolie) besteht. Die Polyesterfolie ist relativ hart und die Kautschukmasse so weich, wie es zur Durchführung von Flexodrucken üblich ist.

In einem ersten Arbeitsgang wird in einem Randabschnitt 3 die Polyestermasse thermisch abgehoben, so daß ein Klischee entsteht, wie es in Fig. 2 abgebildet ist.

In dem Randabschnitt erfolgt dann die Stanzung der Paßlöcher 4. Das so hergestellte Produkt wird auf die Paßstifte 5 der Montageschiene 6 aufgesetzt. Dann werden Distanzstücke 7 aufgelegt, damit der Film 8 glatt mit seinen Paßlöchern 9 glatt auf die Oberfläche der Kautschukmasse 1 aufgelegt werden kann. Die Paßstifte 5 ragen über die Oberfläche hinaus.

Der Film 8 kann durch Anlegen eines Vakuums auf der Kautschukmasse während des nunmehr stattfindenden Belichtens unverrückbar festgehalten werden.

Das auf diese Weise belichtete Klischee wird dann in üblicher Weise ausgewaschen, damit die Abschnitte, die die Druckfarbe aufnehmen sollen, reliefartig vorstehen.

Das fertige Flexodruck-Klischee wird dann vorzugsweise unter Streß, d.h. unter Druck, in der Druckmaschine ebenfalls mit Hilfe entsprechender Paßstifte montiert. Zum Drucken verschiedener Farben werden eine entsprechende Anzahl von Flexodruck-Klischees hergestellt, die aufgrund der exakten Stanzung, Anordnung und Montage, mit Hilfe der Paßstifte ein Druckbild mit der erforderlichen hohen Genauigkeit erzeugen.

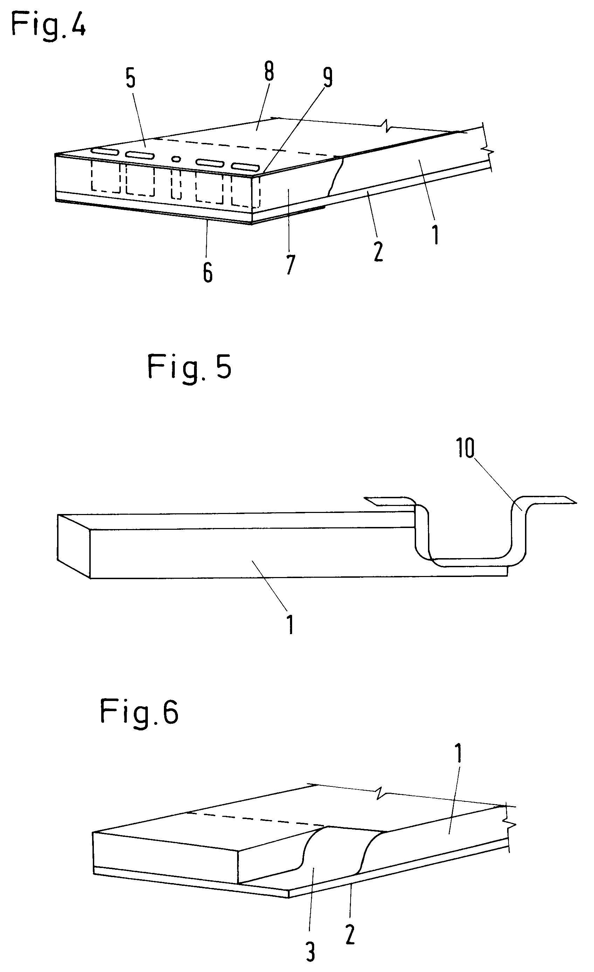

In den Fig. 5 und 6 ist schematisch dargestellt, wie ein thermisches Messer 10 in einem Randabschnitt den entsprechenden Teil der Kautschukmasse abhebt. Die Steuerung und Versorgung des thermischen Messers mit Energie erfolgt nach Feststellung und Abtastung der entsprechenden Parameter mit Hilfe eine Rechners, der insbesondere Temperatur und Vorschub feststellt und das thermische Messer entsprechend steuert.

## Patentansprüche

1. Verfahren zum Herstellen eines Flexodruck-Klischees mit einer Base (Polyesterfolie) und einer auf dieser angeordneten weichen, mit Fotoinitiatoren angereicherten Kautschukmasse (Fotpolymer), bei dem der das zu druckende Motiv aufweisende Film auf der freien Oberfläche der Kautschukmasse passgerecht befestigt wird, dadurch gekennzeichnet, daß
a) die Kautschukmasse (1) an den für die Befestigung vorgesehenen Rändern von der Base (2) entfernt wird;
b) die Base im Bereich dieser freigelegten Ränder mit Paßlöchern (4) versehen und mit diesen auf Paßstifte (5) einer Montageschiene (6) aufgelegt wird;
c) auf die befreiten Ränder Distanzstücke (7) aufgelegt werden, deren Höhe der Höhe der entfernten Kautschukmasse entspricht;
d) der entsprechende Paßlöcher (9) aufweisende Film auf die Paßstifte aufgesetzt wird, und
e) dann die Belichtung, Auswaschung und Montage in der Druckmaschine erfolgt.

2. Verfahren nach Anspruch 1, dadurch gekennzeichnet, daß die mit Fotoinitiatoren angereicherte Kautschukmasse (1) in einer Stärke von 0,5 bis 6,3 mm auf eine Base zwischen 0,12 und 0,23 mm extrudiert und über Kalanderoberflächen homogenisiert wird.

3. Verfahren nach Anspruch 1 oder 2, dadurch gekennzeichnet, daß das Entfernen der Kautschukmasse (1) durch ein elektronisch gesteuertes, thermisches Messer (10) erfolgt, wobei die Höhe der Kautschukmasse auf der Base (1) ebenso wie die Härte der Kautschukmasse abgetastet wird und aus den Daten der gemessenen Kautschukmenge und denen der Härte durch einen Rechner, die zu benötigende Energie für den Abtrennvorgang und für den Vorschub des thermischen Messers ermittelt wird.

4. Verfahren nach Anspruch 3, dadurch gekennzeichnet, daß das thermische Messer durch das stehenbleibende Kautschukmaterial gekühlt wird.

5. Verfahren nach Anspruch 3, dadurch gekennzeichnet, daß für das thermische Messer eine Fremdkühlung vorgesehen ist.
